# EUROPEAN PATENT APPLICATION

(11) **EP 2 657 986 A1**
(43) Date of publication of application: **30.10.2013**
(21) Application number: 12425081.2
(22) Date of filing: 27.04.2012
(51) Int. Cl.: H01L 31/048, H01L 31/042

(54) **A photovoltaic panel and anchoring structure.**

(71) Applicant: Guzzini Engineering S.R.L., 60027 Osimo (AN) (IT)
(72) Inventor: Guzzini, Francesco, 60021 Camerano (AN) (IT)
(74) Representative: Baldi, Claudio

(57) **Abstract**

The present invention relates to a photovoltaic panel comprising a lower bearing plate (1) and an upper plate (2) made of transparent material, among which an intermediate layer is disposed, being formed of a plurality of photovoltaic cells (3) and disposed in turn between two protective coating sheets (4); the lower plate (1) of said photovoltaic panel has the same shape as the upper plate (2), but higher dimensions than the upper plate (2), thus forming a perimeter step (G) with height practically identical to the thickness (S) of the upper plate (2).

## Description

The present patent application relates to a photovoltaic panel and relevant anchoring structure.

In the last few years the use and installation of photovoltaic panels have become more and more popular, since they represent a renewable environmental-friendly alternative to ordinary non-renewable energy sources.

Among all renewable sources, this kind of panels uses solar energy and because of relatively limited costs and relatively easy installation it is used for multiple purposes, both for domestic and non-domestic use.

The performance of said photovoltaic panels depends on a series of factors, among which orientation of panels and cleaning of their collecting surface, meaning by this term the side of the panel adapted to be faced towards the sun.

A poor cleaning of the collecting surface can considerably reduce the performance. Moreover, because of the typical disposition of the collecting surface (facing towards the sun, that is upwards), the collecting surface is easily subjected to the action of contaminating agents, such as rain, dust, smog, fine particles and similar agents.

In view of the above, the collecting surface of the photovoltaic panel must be cleaned on a frequent basis.

Nevertheless, the perfect, rapid cleaning of said collecting surface is hindered by the presence of the network of sections that are normally used to anchor and seal the coplanar series of photovoltaic panels that form the total collecting surface of the solar installation.

To that end, it must be noted that such a kind of installation uses a modular series of photovoltaic panels, laid side by side on the same plane and anchored onto a suitable metal support frame, which is firmly fixed on the roof of the buildings where the system is installed, in case of roof installations, or to ground-anchored frames, in case of ground systems.

Moreover, a traditional photovoltaic panel has a rectangular or square shape and a sandwich structure formed of a lower bearing plate made of any suitable material, and an identical upper plate made of transparent material, generally glass, among which an intermediate layer is disposed, being formed of a plurality of photovoltaic cells and disposed between two protective coating sheets made of plastic material.

The coplanar series of photovoltaic panels is fixed to the support frame by means of fixing brackets situated on the grid of spaces between the side-by-side panels, the interfaced edges of which are interconnected mechanically by means of U-bolts anchored in the lower part to the fixing bracket and laterally surmounting said interfaced pair of edges.

Said grid of spaces is then covered from above by means of a series of sealing sections with suitable shape and dimensions to surmount said interfaced borders for the entire length.

Said sections are normally provided with rubber seals in order to prevent rain or washing water from penetrating through said spaces and leak under the panels.

While on one side said sealing sections guarantee water-tightness of the total collecting surface of the photovoltaic installation, on the other side the same sections make it difficult to clean said collecting surface rapidly and perfectly.

Obviously, said sections originate a grid of ribs protruding above the smooth collecting surface of each photovoltaic panel.

It is demonstrated that dirt tends to accumulate and stagnate in the proximity of said ribs, originating deposits that are difficult to remove with water jet, and also resist to the abrasive action of cleaning brushes.

The present invention has been devised further to a critical examination of said problem, in order to remedy the aforesaid drawback.

In other words, the purpose of the present invention is to design a new model of photovoltaic panel and relevant anchoring structure, including sealing sections, in order to obtain a photovoltaic installation with total collecting surface devoid of projecting elements that may impair the perfect planar continuity of the same surface.

A further purpose of the invention is to provide a photovoltaic panel for a photovoltaic installation using non-conventional modules and special components, specifically developed to integrate and replace architectural elements of buildings, such as:
- roofing;
- opaque vertical surfaces;
- transparent or semi-transparent surfaces on roofing.

An additional purpose of the present invention is to provide a non-conventional photovoltaic panel designed and industrially manufactured in order to produce electricity and additionally carry out other fundamental architectural functions, such as thermal protection or regulation of the building, and also suitable to guarantee water seal and consequent water-tightness of the building.

Another purpose of the invention is to obtain a new photovoltaic panel that can be mounted with any inclination, passing from a perfectly horizontal to a perfectly vertical position.

It must be noted that the photovoltaic panel of the invention can be used to obtain a vertical surface that represents the external element of a ventilated façade of a building.

These purposes are achieved by the present invention, the innovative characteristics of which are claimed in the attached independent claims, whereas the dependent claims, describe preferred embodiments of the invention, forming an integral part of the present description.

The new model of photovoltaic panel according to the invention traditionally has a sandwich structure formed of a lower bearing plate and an upper plate made of transparent material, among which an intermediate layer is disposed, being formed of a plurality of photovoltaic cells and disposed between two protective coating sheets made of plastic material.

The characteristic of said new model of photovoltaic panel consists in the fact that the lower plate has higher dimensions, in terms of width and length, than the upper plate, thus forming a perimeter step with height practically identical to the thickness of the upper plate.

In view of the above, between the interfaced edges of two of said panels a space with T-shaped section is left, which can be covered with a corresponding sealing section, the head wing of which is perfectly fitted inside said space, flush to the collecting surface of the two adjacent panels.

For explanatory reasons, the description of the device according to the present invention continues with reference to attached drawings, which only have illustrative, not limiting value, wherein:
- Fig. 1 is an exploded view of the photovoltaic panel of the invention, sectioned with a vertical plane;
- Fig. 2 is a view of the space separating the longitudinal interfaced edges of an adjacent pair of photovoltaic panels according to the invention, installed and sectioned with a vertical plane perpendicular to said interfaced longitudinal edges;
- Fig. 3 is a view of the space separating the transversal interfaced edges of an adjacent pair of photovoltaic panels according to the invention, installed and sectioned with a vertical plane perpendicular to said transversal edges;
- Fig. 4 is a sectional view with a vertical plane of an edge of the photovoltaic panel according to the invention.

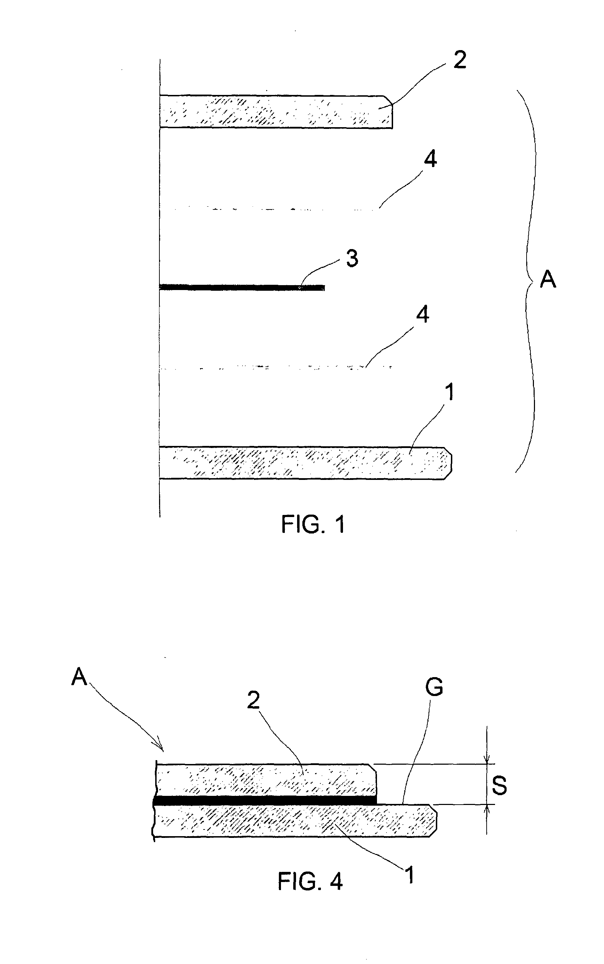

Referring to Fig. 1, the photovoltaic panel (A) according to the invention has a sandwich structure comprising a lower bearing plate (1) preferably made of glass, an upper plate (2) likewise made of glass, among which an intermediate layer is disposed, being formed of a plurality of photovoltaic cells (3) and disposed between two protective coating sheets (4) preferably made of EVA (ethyl-vinyl-acetate).

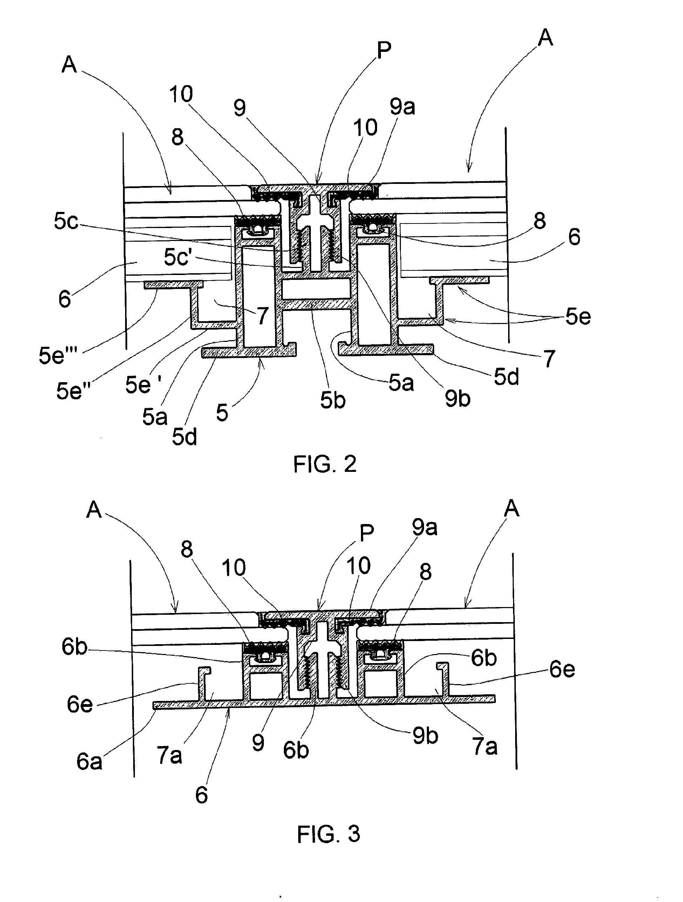

The characteristic of this new model of photovoltaic panel (A) consists in the fact that, in spite of having the same shape as the upper plate (2), the lower plate (1) has higher width and length than the upper plate (2), thus forming a perimeter step (G) with height basically equal to the thickness (S) of the upper plate (2), as shown in Figs. 2 and 3.

According to the preferred embodiment of the present invention, the plates (1 and 2) are composed of two glass plates with 4 mm thickness, whereas the edges of the lower plate (1) protrude from the edges of the upper plate (2) by 7.5 mm.

As mentioned above, the present invention also relates to the anchoring structure of the photovoltaic panels (A), including the sealing sections (P) of the spaces separating the interfaced edges of the adjacent pairs of panels (A) after installation.

Referring to Fig. 2, said anchoring structure consists in a grid of metal sections connected at right angle, comprising:
- -upright sections (5) in parallel position to the inclination direction of the panels (A) with respect to a horizontal plane;
- transversal sections (6) in perpendicular position to said upright sections (5).

Said anchoring structure also comprises multiple sealing sections (P) used to cover the spaces separating the interfaced edges of the adjacent pairs of panels (A).

Said upright sections (5) are made of extruded aluminum and provided with H-shaped tubular section, comprising two identical vertical wings (5a) connected by a horizontal transversal wing (5b), from the center of which a close pair of vertical partitions (5c) protrudes, with external walls (5c') provided with serrate profile.

Said vertical wings (5a) are provided with enlarged support feet (5d) to improve both stabilization on support surface and fixing on roofing of the building where the photovoltaic installation is installed.

In external position to each of said vertical wings (5a) a Z-shaped shelf (5e) is provided, comprising:
- a first horizontal section (5e');
- a second vertical section (5e');
- a third horizontal section (5e"');

The first two sections (5e' and 5e") contribute to define, together with the corresponding vertical wing (5a), a U-shaped channel (7) used as collection and drain channel for water penetrating under the sealing sections (P).

Said third horizontal section (5e"') acts as support plane for the ending portions of the transversal sections (6).

Finally, attention is drawn on the fact that said vertical wings (5a) are provided on the head with seals (8), where the longitudinal edges (1 a) of the lower plate (1) lie. As shown in Fig. 2, said sealing sections (P) are obtained by cutting to size an aluminum extruded section (9) with T-shaped cross-section, the head wing (9a) of which surmounts the steps (G) of both panels (A) in planar alignment with the upper plates (2) of the two adjacent panels (A).

The vertical wing (9b) of said section (9) has an internally serrated forked section, which is adapted to embrace the close pair of vertical partitions (5c) with male-female coupling.

Under the head wing (9a) seals (10) are provided, practically covering said step (G) positioned between said head wings and the longitudinal edges (1 a) of the lower plate (1).

Referring to Fig. 3, said transversal sections (6) are made of extruded aluminum and provided with cross-section formed of a large base platform (6a) from which the following elements protrude:
- a pair of tubular vertical wings (6b) provided on the head with seals (8);
- a close pair of vertical partitions (6c), the external walls (6c') of which have a serrate profile, being said pair of partitions (6c) interposed between the pair of wings (6b);
- two upright edges (6e) respectively situated in external position at a certain distance from said wings (6b).

Said upright edges (6e) contribute to define, together with the base platform (6a) and the vertical wing (6b), a U-shaped channel (7a) used as collection and drain channel for water penetrating under the sealing sections (P).

Said close pair of vertical partitions (6c) is adapted to be fitted inside the vertical wing (9b) with forked profile of said section (9) with male-female coupling.

## Claims

**1.** A photovoltaic panel comprising a lower plate (1) and an upper plate (2) made of transparent material, among which an intermediate layer is disposed, being formed of a plurality of photovoltaic cells (3) and disposed between two protective coating sheets (4), a photovoltaic panel (A) **characterized in that** the lower plate (1) has the same shape as the upper plate (2), but higher dimensions than the upper plate (2), thus forming a perimeter step (G) with height practically identical to the thickness (S) of the upper plate (2).

**2.** A photovoltaic panel as claimed in the preceding claim, **characterized in that** the plates (1 and 2) are both made of glass and the two protective coating sheets (4) are made of EVA.

**3.** An anchoring structure for a series of photovoltaic panels (A) as described in any one of the preceding claims, consisting in a grid of metal sections connected at right angle, comprising:
- -upright sections (5) in parallel position to the inclination direction of the panels (A) with respect to a horizontal plane;
- transversal sections (6) in perpendicular position to said upright sections (5);
a structure **characterized in that** said upright sections (5) are made of extruded aluminum and provided with tubular section, which basically has an H-shaped section, comprising two identical vertical wings (5a) provided on the head with seals (8) and connected by a horizontal transversal wing (5b), from the center of which a close pair of vertical partitions (5c) protrudes, with external walls (5c') provided with serrate profile.

**4.** An anchoring structure as claimed in the preceding claim, **characterized in that** in external position on each of said vertical wings (5a) a longitudinal channel (7) is obtain to collect and drain water.

**5.** An anchoring structure as claimed in the preceding claim, **characterized in that** a Z-shaped shelf (5e) is provided in external position on each of said vertical wings (5a), comprising:
- a first horizontal section (5e');
- a second vertical section (5e');
- a third horizontal section (5e"');
where the first two sections (5e' and 5e") contribute to define, together with the corresponding vertical wing (5a), said longitudinal channel (7) with U-shaped section.

**6.** An anchoring structure for a series of photovoltaic panels (A) as described in any one of the preceding claims 1 or 2, consisting in a grid of metal sections connected at right angle, comprising:
- -upright sections (5) in parallel position to the inclination direction of the panels (A) with respect to a horizontal plane;
- transversal sections (6) in perpendicular position to said upright sections (5);
a structure **characterized in that** said transversal sections (6) are made of extruded aluminum and provided with cross-section formed of a large base platform (6a) from which the following elements protrude:
- a pair of tubular vertical wings (6b) provided on the head with seals (8);
- a close pair of vertical partitions (6c), the external walls (6c') of which have a serrate profile, being said pair of partitions (6c) interposed between the pair of wings (6b).

**6.** An anchoring structure as claimed in the preceding claim, **characterized in that** a transversal channel (7) is obtained in external position on each of said vertical wings (6a) to collect and drain water.

**7.** An anchoring structure as claimed in the preceding claim, **characterized in that** from the platform (6) two upright edges (6e) protrude, respectively disposed in external position and at a certain distance from the wings (6b), which contribute to define - together with said base platform (6a) and vertical wing (6b) - said transversal channel (7a) with U-shaped section.

**8.** An anchoring structure as claimed in one of claims 3 to 7, **characterized in that** it comprises sealing sections (P), each of them consisting in an aluminum extruded section (9) with T-shaped cross-section, the head wing (9a) of which is adapted to surmount the interfaced steps (G) of an adjacent pair of panels (A) in planar alignment with the upper plates (2) of the two adjacent panels (A).

**9.** An anchoring structure as claimed in the preceding claim, **characterized in that** the vertical wing (9b) of said section (9) has an internally serrate forked section, adapted to embrace said close pair of vertical partitions (5c,6c) with male-female coupling.

**10.** An anchoring structure as claimed in the preceding claims, **characterized in that** seals (10) are provided under the head wing (9a), practically covering said step (G), being disposed between said head wings (9a) and the edges of the lower plate (1).
